# EUROPEAN PATENT APPLICATION

(11) **EP 3 182 589 A1**
(43) Date of publication of application: **21.06.2017**
(21) Application number: 15200708.4
(22) Date of filing: 17.12.2015
(51) Int. Cl.: H03K 5/13, H03K 5/00

(54) **DELAY CONTROL CIRCUIT**

(71) Applicant: IMEC VZW, 3001 Leuven (BE)
(72) Inventor: CRANINCKX, Jan, 3001 Leuven (BE); INGELS, Mark, 3001 Leuven (BE)
(74) Representative: DenK iP

(57) **Abstract**

The present invention relates to a delay control circuit arranged for adding delay to a signal. The delay control circuit comprises
- a driver circuit (10) arranged to receive a signal (11) and to output a delayed signal (12) and comprising a variable load (20) arranged for adding delay to said signal,
- a control circuit (30) arranged to receive the signal (12) and to control the variable load of the driver circuit based on a current state of the signal and on a control signal (external) indicative of an amount of delay to be added to the signal in the current state.

## Description

### Field of the invention

The present invention is generally related to the field of circuits for delaying timing signals.

### Background of the invention

In many applications precise control of the timing of clock signals and other signals is required. An input signal is provided, but both its delay and duty cycle must be adjusted in order to fit the system requirements.

Digital RF transmitters combine the functionality of digital-to-analog conversion and RF transmission in a single block. A typical DAC comprises an array of current cells, which are switched on and off at a baseband sampling rate F_{S}, typically up to a few hundreds of MS/s. In a digital RF transmitter this control itself is toggled at the rate of the local oscillator frequency F_{LO}, typically a few GHz, to ensure the output signal is transmitted in a frequency band around F_{LO}. The DAC elements can be arranged in a binary-coded array, a thermometer-coded array or a combination thereof.

The quality of the transmitted signal heavily depends on the precision of the generated current pulses, both in amplitude and phase. Mismatch in the value of the 2^{N} current sources deteriorates the RF performance, like the in-band signal quality expressed in EVM (error vector magnitude), but even more importantly, the out-of-band signal quality, where several undesired (and non-allowed) signal transmissions can occur. For high accuracies, where design-for-matching is not practical anymore, these current pulses must be individually calibrated to eliminate those errors.

If the delay of the rising and the falling edge of the input pulses can be controlled independently, both the amplitude and phase of the output current pulse can be controlled. The required accuracy is in the range of 0.1psec, which is very small compared to the typical gate delay of e.g. 10 psec.

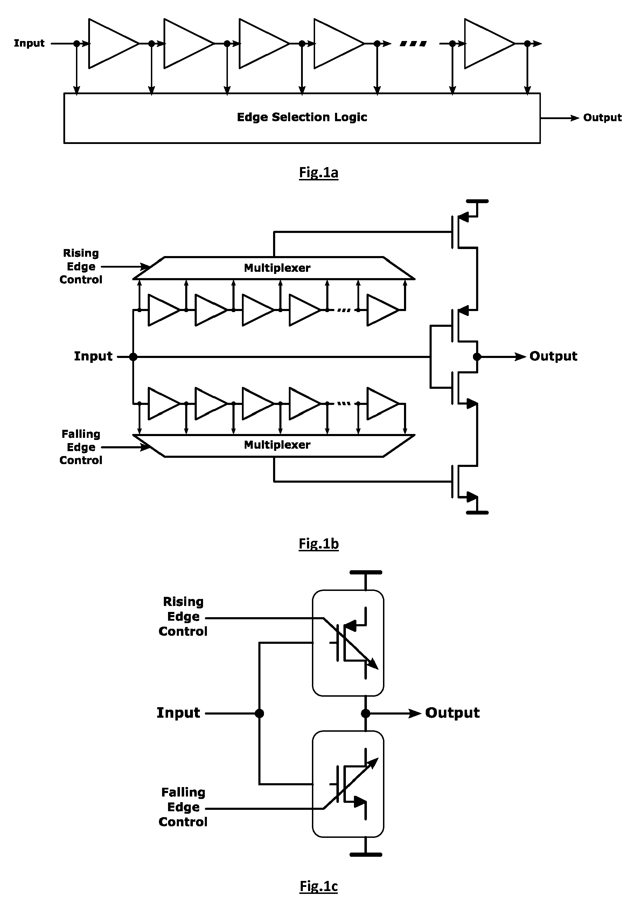

This problem has already been addressed in the prior art many times. However, the proposed solutions suffer from the fact that they only have a coarse accuracy. In US6424197 it is proposed to generate the desired output signal based on a set of delayed versions of the input signals and an edge selection circuit, as depicted in Fig.1a. The delayed signals are generated by driving the input signal through a chain of delay elements. The edge selection circuit typically contains two multiplexers that are used to select two of the delayed signals and a combination circuitry which typically includes a logic circuit. If the logic circuit is equivalent to an AND gate, the output signal will have a rising edge corresponding to the rising edge of the first delayed signal and a falling edge corresponding to the falling edge of the second delayed signal. If the logic circuit is equivalent to an OR gate, this correspondence is swapped. Hence an output signal is generated that can have independent control of its rising and falling edge. This approach, however, can only provide very coarse delay steps, in the order of magnitude of one or two gate delays, typically 10-20 psec.

A similar technique is used in US7598784, with the minor difference that now two separate delay lines are used to select the delayed signal that determines the rising or falling edge, as depicted in Fig.1b. The two multiplexers again select a signal from their respective delay line. The functionality of the combination logic is implemented in the four transistors of the output stage. Since its basic mode of operation is essentially the same as in US6424197, it suffers from the same disadvantage of very coarse delay steps and, hence, not enough accuracy for application in an RF transmitter.

US7102407 discloses a programmable clock delay circuit comprising an input/output circuit, a falling edge delay circuit and a rising edge delay circuit. The input/output circuit receives a reference signal and outputs a delayed signal. It presents a technique (depicted in Fig.1c), which does not have this intrinsic limitation of gate delay accuracy. It operates on the principle that the delay of a logic circuit or buffer that drives a certain load is proportional to the ratio of *I*/*C*, where C is the load capacitance at the output and I the drive current generated by the buffer. In any CMOS circuit the drive current for a falling edge will be determined by the strength of the NMOS transistors in the circuit, while the drive current for a rising edge will be determined by the strength of the PMOS transistors. Hence, this technique tries to modify the properties of the NMOS transistors to influence the delay of the falling edge. The transistor properties can be modified by e.g. using a set of one or more transistors in parallel for faster operation or less delay, and one or more transistors in series for slower operation and more delay. Similarly, the PMOS properties are modified to control the rising edge delay.

There are, however, some disadvantages to this technique. First, the drive strength of the transistors can only be controlled with a limited accuracy. Finer steps would mean adding extra transistors of a very small width of which the parasitics would become too important and degrade the overall performance. Second, the overall implementation takes up a rather large area and is, hence, not feasible in the system of a digital RF transmitter where many of these delay control systems are needed to individually control all the current pulses.

Hence, there is a need for a delay control circuit capable of adjusting delays with high accuracy.

### Summary of the invention

It is an object of embodiments of the present invention to provide for a delay control circuit that allows adding delay in small amounts, thus yielding a solution with high resolution.

The above objective is accomplished by the solution according to the present invention.

In a first aspect the invention relates to a delay control circuit arranged for adding delay to a signal. The delay control circuit comprises
- a driver circuit arranged to receive a signal and to output a delayed version of the received signal and comprising a variable load arranged for adding delay to said signal,
- a control circuit arranged to receive said signal and to control the variable load of the driver circuit based on a current state of the signal and on a control signal indicative of an amount of delay to be added to the signal in the current state.

The proposed solution indeed allows for adding delay with high accuracy. The signal to be delayed is received in a variable load circuit of the driver circuit. The load circuit is controlled by a control circuit. This control circuit also receives the delayed signal and controls the variable load circuit by detecting the current state of the output signal and sending a control signal indicating an amount of load to be added in order to generate the desired amount of delay. The variable circuit then adapts the load based on the information contained in the control signal. The variable load circuit allows for much more accurate delay control, since it is in a typical CMOS process very easy to increase or decrease the load in steps of e.g. 0.1 fF. This results in delay steps of e.g. 0.1 psec, orders of magnitude smaller than a typical gate delay. Comparing to the technique that controls the delay by modifying the NMOS or PMOS drive current, it is noted that a similar accuracy would require modifying the equivalent width of the transistors in increments of e.g. 10 nm, a value which cannot be efficiently realised.

In a preferred embodiment the variable circuit is arranged for adding a first delay when the current state of the signal being output is a logic 'low'. The control circuit then knows that the next output edge will be a rising edge. Hence, it sends a control signal to the variable load that corresponds to the desired delay for a rising edge and this amount of delay will be added on a rising edge. Even more preferably the variable circuit is also arranged for adding a second delay when the current state of the output signal is a logic 'high'. The next edge then is a falling edge and the corresponding control signal is given. Hence, the detection of a logic low or high state (rising or falling edge) in the signal to be delayed triggers the addition of a certain amount of delay. The amount added when a low state is detected is so independent of the amount of delay added when a high state is detected.

In one embodiment the delay control circuit comprises a rising edge delay circuit. In another embodiment, preferably in combination, the delay control circuit comprises a falling edge delay circuit.

In one embodiment the variable load circuit is an array of switchable capacitors.

Alternatively, the variable load circuit is an array of switchable varactors. In a preferred embodiment the delay control circuit then comprises at least one switchable PMOS varactor for a rising edge. In a preferred embodiment the delay control circuit then comprises at least one switchable NMOS varactor for a falling edge.

In another embodiment the variable load circuit comprises varactors for a rising edge. In a further embodiment the variable load circuit comprises varactors for a falling edge.

The invention also relates to a direct digital radio frequency modulator comprising a plurality of converter circuits, at least one of said converter circuits being provided with a delay control circuit as previously described.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates some prior art solutions.
Fig.2 illustrates an RF DAC as considered in the present invention.
Fig.3 illustrates a block scheme of a delay control circuit according to the invention.
Fig.4 illustrates the behaviour of an NMOS varactor used in an embodiment of the invention.
Fig.5 illustrates the behaviour of a PMOS varactor used in an embodiment of the invention.
Fig.6 illustrates the combination of a set of the NMOS and PMOS varactors of Fig.4 and Fig.5, respectively.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

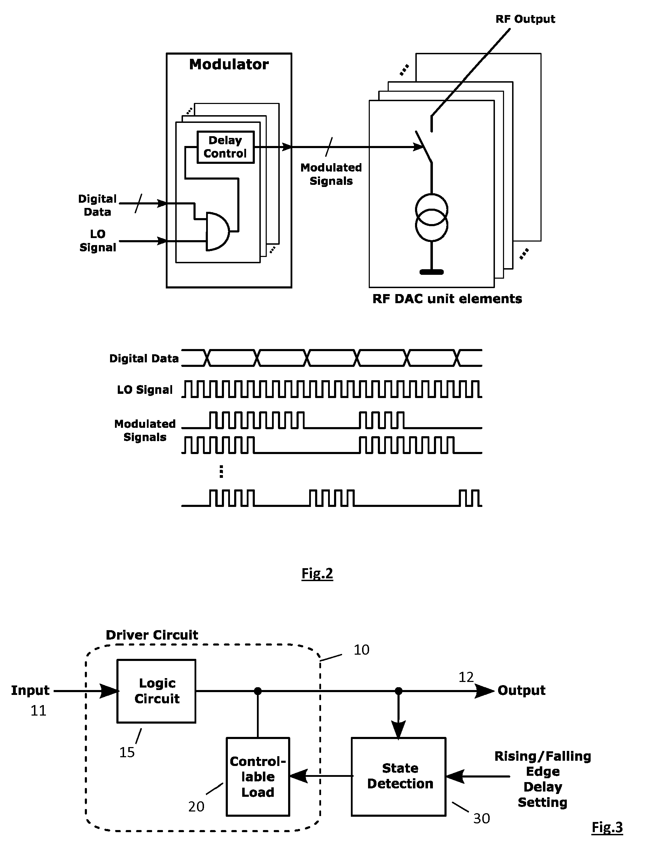

A general view on a RF DAC is provided in Fig.2. Modulated LO signals are created in the various circuits (i.e. AND gates) in the modulator by windowing an applied local oscillator (LO) signal with baseband data. The various circuits are individually switched on/off at the LO speed. Delay control is performed on the modulated signals. The resulting modulated signals are fed to the RF DAC unit elements, which each receive their modulated signal and generate a corresponding RF output signal.

The invention proposes a delay control circuit capable of adding delay to an incoming signal (11) in incremental amounts. In order to achieve an efficient realisation, the delay control circuit is designed to control the load capacitance, rather than to work on the drive current to control the delay. Fig.3 illustrates a block scheme of the basic set-up. A driver circuit (10) provides via its logic circuit (15) a signal to be delayed. This signal is fed to a variable load circuit (20) in the driver circuit (10) and to a control circuit (30) capable of signal state detection. The actual delay is added to the signal in the variable load circuit. By modifying the load (capacitance) on the output node a controllable delay on the applied signal is generated. The variable load circuit (20) is under control of the control circuit (30), which detects the current state of the signal and receives a delay setting by an external control circuit. This delay setting is programmable and can change over time. It may be different for the rising and falling edge. The control circuit sends a control signal to adjust the variable load circuit according to the detected current state and the programmed amount of delay.

In an advantageous embodiment a first delay is added to the signal when the detected current state is a logic 'low' and, hence, indicates the occurrence of a rising edge of the signal being output. The proposed solution allows for such a separate delay. Typically a rising edge delay circuit is provided. A second delay, possibly different from the first, can be added when the current state of the signal is a logic 'high' and, hence, corresponds to a falling edge. A falling edge delay circuit may be provided. In this way the invention achieves separate delay control on rising and falling edges. It is one of the main advantages of the proposed delay control circuit that separate control of the two signal edges is possible.

The variable load circuit (20) is in one embodiment implemented with an array of switchable capacitors, which are controlled via the control signal from the control circuit.

An interesting alternative to build the load circuit (20) can be the use of an array of switchable varactors. The varactors are so controlled that some of them are active only on the rising edge of the signal and others only on the falling edge. This is done by using also a delayed version of the output signal as a varactor state control, such that after the corresponding edge has occurred, the varactor automatically deactivates itself for the next (opposite sign) edge. As opposed to the prior art solutions, this allows independently controlling the delay of the falling and rising edges in very small increments. A minimal-sized varactor has a typical size of 0.1 fF in a modern CMOS technology, which allows controlling the delay added easily in steps of 0.1 psec or smaller. Note that in case of an embodiment with switchable capacitors a similar argument can be developed to achieve such a small resolution step. The control of the capacitors can be done as before, allowing separate control of the rising and falling edge.

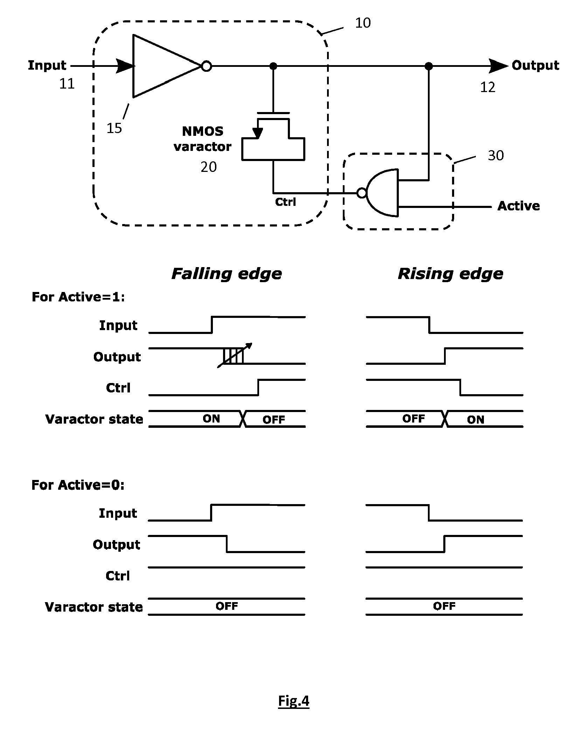

Two different types of varactors are used for controlling the edges : an NMOS varactor controls the rising edge delay and a PMOS varactor the falling edge delay. The NMOS varactor (see Fig.4) is 'on' when its gate voltage is high (i.e. Output = 1) and its drain/source voltage is low. This is the case at the moment when the upcoming edge of the output signal (12) is a falling edge and, hence, a delay is introduced on this falling edge. After this event, the varactor goes to an 'off' state because its gate voltage is now low. Also the drain/source voltage is set to high by the feedback from the signal being output. It is crucial to note that this change of state only occurs *after* the delay has been added to the output edge. The timing on this is very relaxed. Hence, when the next edge occurs, which is always a rising edge, (see Fig.4), the NMOS varactor is in its 'off' state and represents a much smaller load capacitance (only the parasitics) for the buffer, so this edge is not delayed. Again, it is only after the rising edge transition has occurred that the varactor changes state again and is ready to perform its loading function on the next upcoming falling edge. An extra NAND gate (or any other logic circuit with the same functionality) is added in the varactor feedback control to decide if a rising edge delay should be added or not. If a high control signal is used, the functionality is described as above. If a low control signal is given, the drain/source voltage of the varactor is always high, so the capacitance value is always low, and no delay is added to the either edge.

A number of such unit varactor elements can be added to the output node, controlled by a number of bits on their respective NAND gates (or equivalent logic), to program the desired rising edge delay over a certain range. The delay generated is more or less linearly proportional to the number of active varactors.

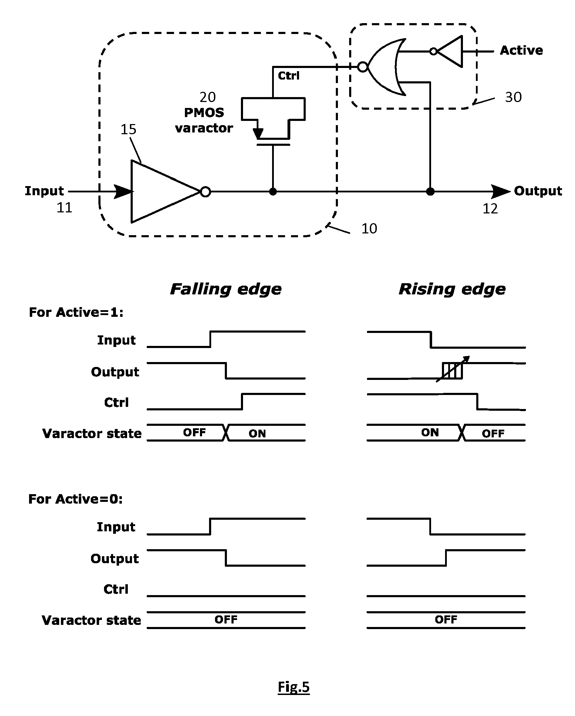

For the falling edge a PMOS varactor is used, which can be described in a similar way. The PMOS varactor (see Fig.5) is 'on' when its gate voltage is low (i.e. Output = 0) and its drain/source voltage is high. This is the case at the moment when the upcoming edge of the output signal (12) is a rising edge and, hence, a delay is introduced on this rising edge. For a falling edge, the PMOS varactor is always in the 'off' state, and hence no delay is added. An extra inverter and NOR gate (or any other logic circuit with the same functionality) are added now, which needs a low control signal to implement the desired falling edge delay functionality. If a high control signal is given, the varactor is always in the 'off' state, so no load is added to the output node and no delay is added to either edge.

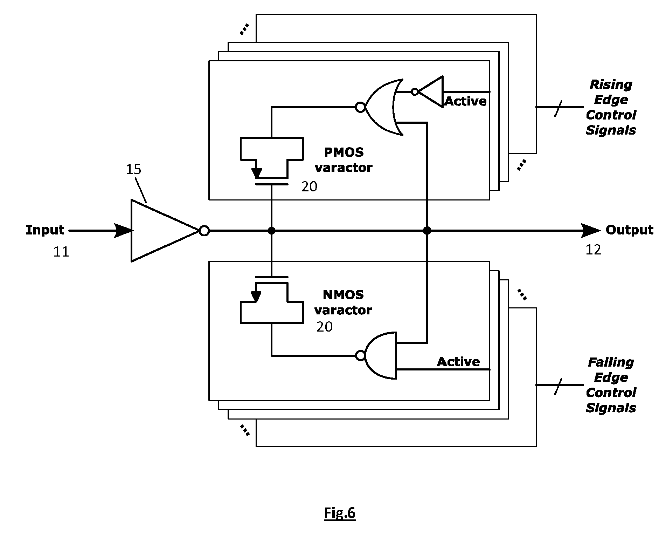

Both delay control elements (NMOS and PMOS varactors) can be added on the output node of the same buffer to control the delay of the rising and falling edge independently. Fig.6 represents an implementation with both a rising edge delay circuit (top) and a falling edge delay circuit (bottom).

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Delay control circuit arranged for adding delay to a signal, the delay control circuit comprising
- a driver circuit (10) arranged to receive a signal (11) and to output a delayed signal (12) and comprising a variable load (20) arranged for adding delay to said signal,
- a control circuit (30) arranged to receive said signal (11) and to control said variable load of said driver circuit based on a current state of said signal and on a control signal indicative of an amount of delay to be added to said signal in said current state.

2. Delay control circuit as in claim 1, wherein said variable circuit is arranged for adding a first delay when said current state of said signal corresponds to a rising edge.

3. Delay control circuit current state as in claim 1 or 2, wherein said variable circuit is arranged for adding a second delay when said current state of said signal corresponds to a falling edge.

4. Delay control circuit as in any of the previous claims, comprising a rising edge delay circuit.

5. Delay control circuit as in any of the previous claims, comprising a falling edge delay circuit.

6. Delay control circuit as in any of the previous claims, wherein said variable load circuit is an array of switchable capacitors.

7. Delay control circuit as in any of the previous claims, wherein said variable load circuit is an array of switchable varactors.

8. Delay control circuit as in claim 7, wherein said variable load circuit comprises varactors for a rising edge.

9. Delay control circuit as in claim 7 or 8, wherein said variable load circuit comprises varactors for a falling edge.

10. Delay control circuit as in claim 7, comprising at least one switchable PMOS varactor for a rising edge.

11. Delay control circuit as in claim 7, comprising at least one switchable NMOS varactor for a falling edge.

12. A direct digital radio frequency modulator comprising a plurality of converter circuits, at least one of said converter circuits being provided with a delay control circuit as in any of claims 1 to 10.
